# EUROPEAN PATENT SPECIFICATION

(11) **EP 2 098 047 B1**
(45) Date of publication and mention of the grant of the patent: **23.02.2011**
(21) Application number: 07859226.8
(22) Date of filing: 24.12.2007
(51) Int. Cl.: H04M 1/02, H05K 5/00

(54) **SUPPORT PANEL FOR VIDEO DOOR ENTRY STATIONS WITH CONCEALED FIXING**
TRÄGERPLATTE FÜR VIDEO-TÜREINGANGSSTATIONEN MIT VERBORGENER ANBRINGUNG
PANNEAU DE SUPPORT POUR POSTES DE PORTIERS VIDÉO COMPORTANT UNE FIXATION MASQUÉE

(30) Priority: 28.12.2006 IT MI20062532
(43) Date of publication of application: 09.09.2009
(73) Proprietor: Bticino S.p.A., 20154 Milano (IT)
(72) Inventor: GATTI, Guido, Giulio, Vittorio, I-22031 Albavilla (Como) (IT); CASTIGLIONI, Massimo, I-22070 Casnate con Bernate (IT)
(74) Representative: Mati, Silvia
(86) International application number: PCT/IB2007/004159
(87) International publication number: WO 2008/081321

(56) References cited:
- EP-A- 0 508 235
- WO-A-2005/029830
- FR-A- 2 707 821
- FR-A- 2 722 028

## Description

The present invention generally refers to a support panel for video entry door stations with concealed fixing.

In particular, the invention regards a support for video entry door modules applicable to outside stations, wherein the support can be concealably fixed with extreme ease by the installer.

Today, from one same phonic apparatus, it is possible to control the entrance, communicate with different parts of the house and be in telephone contact with various outside users.

A new era will be inaugurated in the mid-term future, in which everyone, in all houses, can organise everything from a single "director" station, and in which the need to simplify the life and work of each person is increasingly evident. There is also the need to simplify the life and work of the installers, without having to give up any of the system functions. It is in fact clear that, from the cheapest phonic system to that with the most functions (according to the number of apartments and functions desired), it is in any case necessary to facilitate and quicken the installation, in order to reduce the times and costs of the cabling as well as the possibility for committing errors.

On the other hand, the integration of a system, whether telephone, video door entry, electric or electronic, involves a specific installation and a characteristic functioning thereof, and currently requires the use of different products, often not standardised and thus incompatible with each other.

This causes considerable drawbacks, since the products must be separately made for every need and, consequently, the installations are conditioned by the type and size of each apparatus and by the specific cabling.

In particular, the management of the video door entry systems, above all if relatively complex or particularly extensive, is extremely difficult as a function of the client's increasingly greater needs. This is due to the prolongation of the production and installation times, and consequent increase of the costs, since the assembly of the outside stations currently takes place by using different types of embedded or surface frames, adapted to house a series of functional modules, which must be electrically connected on the back of the outside station and then assembled to the frame.

Finally, the frames of the video door entry stations currently in use have a series of screws or analogous wall-fixing means, which complicate their installation operation and often damage their overall appearance.

### <insert page 3a>

In the scope of the abovementioned needs, therefore, the object of the present invention is that of making a support panel for video door entry systems with concealed fixing, which results easily installable by the operator and which combines, in one same structure, the advantages given by the modularity of the electrical and electronic functioning apparatuses (the so-called video door entry modules), which can be simply placed and connected inside the positioning frames, with a substantial additional mechanical compatibility of the wall-fixing system, which does not damage the overall aesthetic finishing.

Another object of the present invention is that of making a support panel for video door entry stations with concealed fixing which simplifies and facilitates the operations of installation and electrical cabling, such that the setting of the system can be carried out in a simple manner and also by not particularly qualified operators.

Further object of the invention is that of making a support panel for video door entry systems with concealed fixing which is extremely efficient, functional, safe and reliable and which ensures a very high mounting flexibility of the video door entry

Document WO 2005/029830 discloses a door station which comprises a housing which can be embedded in a wall and a frame panel which can house a plurality of modules, wherein the frame panel can be removably fixed to the housing by means of a spring-loaded latching slide having a hook which engages in a corresponding notch in the housing.

Document FR 2722028 describes a container made of a box body and a lid hinged to the same, wherein the container is provided with a locking device formed by two sliders spring loaded to normally enter into positions in the lid, the two sliders having orifices with inclined planes which allow the insertion of a key in order to increase the overlap of the sliders and withdraw the sliders from the lid.

Document FR 2707821 discloses a control panel which comprises a frame serving to accommodate modules, the frame having seats intended for corresponding modules. Document EP 0508235 describes a door installation, especially a door interphone, with a housing, a rectangular receiving frame (1), several function units and possibly sealing and masking means, wherein the receiving frame receiving the function units is lockably connected to the housing.

modules, as well as a particularly quick assembly, maintenance and substitution of the parts.

These and other objects, according to the present invention, are achieved by making a support panel for video door entry systems with concealed fixing, according to the enclosed claim 1; other detailed technical characteristics are illustrated in the subsequent claims.

Advantageously, the video door entry systems of the support panel according to the invention can be designed for analogue systems, simplified and multifunction digital systems or for mixed systems (analogue and digital).

Such functional modules are composed of electrical and electronic apparatuses (loudspeaker, microphone, call buttons, digital module and other accessories) which are assembled together in housings made on the frame of the video door entry system.

Advantageously, the modules can be attached from the outside towards the inside of the frame, in a front position of the same, by means of a mechanical snap fixing system.

Moreover, a particular concealed fixing mechanism is used for attaching the support panel to the frame, according to which an extruded section bar, adapted to house the functional modules of the video door entry system, can be coupled to and released from the frame by means of a suitable key; this permits avoiding the use of screws and other fixing means on the external plate.

Finally, the cover fronts of at least two video door entry modules can be substituted with a single-block front, which, based on the arrangement of the control elements and indication elements placed on the outer surface, indicates which and how many modules are present.

Further characteristics and advantages of a support panel for video door entry stations with concealed fixing, according to the present invention, are clearer from the following exemplifying and non-limiting description, referred to the enclosed figures, wherein:
- Figure 1 is a front view of a first embodiment of a support panel for video door entry stations with concealed fixing, according to the present invention;
- Figures 2 and 3 represent respective side views of the support panel of figure 1;
- Figure 4 is a front view of a second embodiment of a support panel for video door entry stations with concealed fixing, according to the present invention;
- Figures 5 and 6 represent respective side views of the support panel of figure 4;
- Figure 7 is a partial exploded top view of the support panel for video door entry stations, according to the present invention;
- Figure 8 is a partial exploded bottom view of the support panel for video door entry stations, according to the present invention;

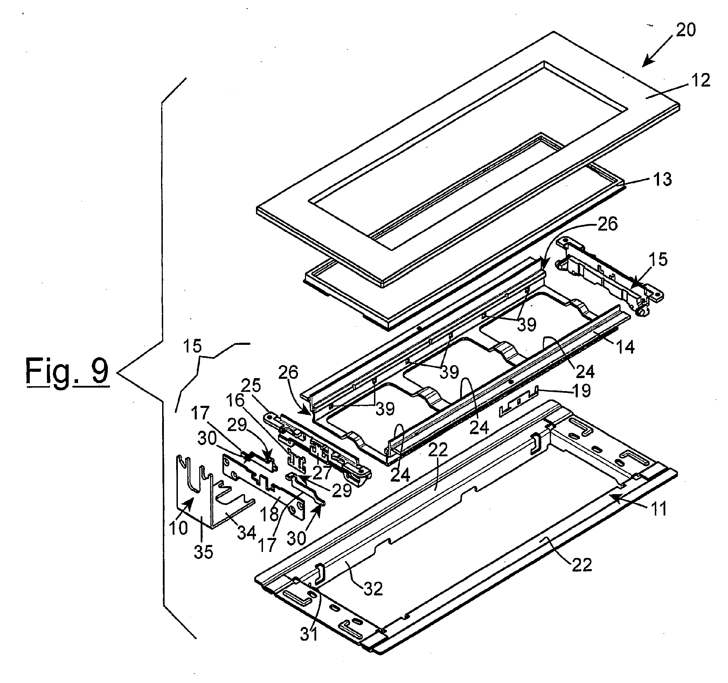

- Figure 9 is a total exploded view of the support panel for video door entry stations with concealed fixing, according to the present invention;
- Figure 10 is a first partial perspective detail view of a portion of the support panel for video door entry stations with concealed fixing, according to the present invention;
- Figure 11 is a second partial perspective detail view of the portion of the support panel of figure 10, according to the present invention;
- Figures 12A and 12B are respective partial perspective detail views of the portion of the support panel of figure 10, according to the invention, in two different opening steps;
- Figures 12C and 12D are respective partial perspective detail views of the portion of the support panel of figure 10, according to the invention, in two different closing steps;
- Figure 13 shows an exploded perspective view of a support panel for video door entry stations with concealed fixing, according to the present invention, in which an assembly mode is shown of a video door entry module.

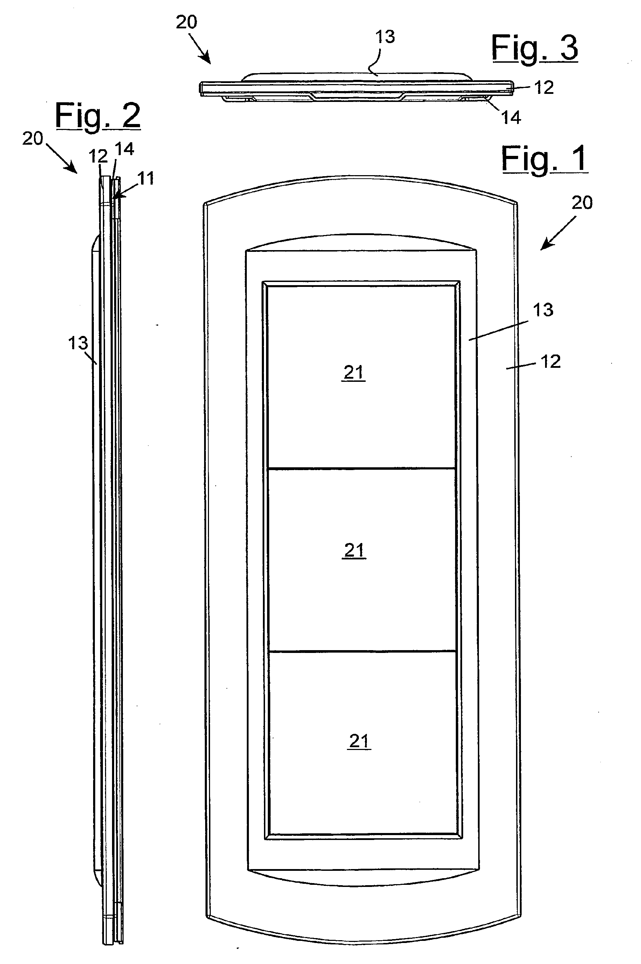

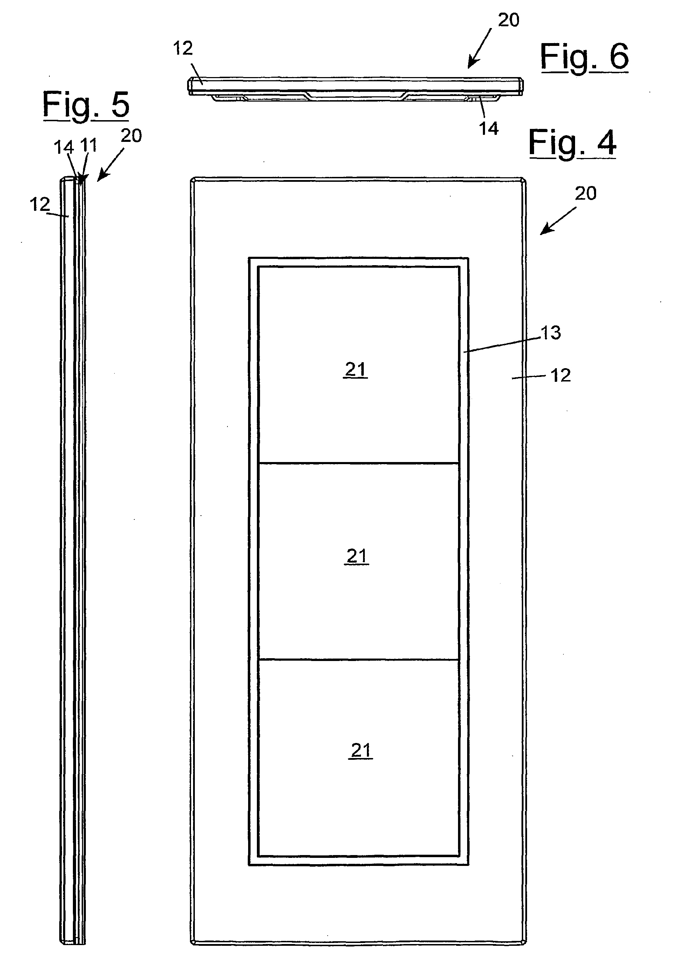

With particular reference to abovementioned figures 1-6, 11 generically indicates the frame of the support panel 20 for video door entry stations, according to the present invention, which can be mounted embedded inside the wall or inside an appropriate containment space or flush with the wall or in any case fixed on a specific base surface.

An under-plate extrusion is indicated with 14, fixed to the frame 11, a shaped front finishing plate is indicated with 12, usually made of brass or steel, while a fixing frame is indicated with 13, variously shaped and employed as position containment element of the modules 21, whether they are phonic modules, buttons, cameras, call keys, etc., and as surface finishing element of the support panel 20.

Moreover, if the support panel 20 is embedded inside the wall, once the fixing frame 13 is mounted it remains flush with the plate 12, projecting out from the wall for a height equal to the thickness of the plate 12 itself, and has one or more access seats for the insertion of the various functional modules 21, which make up the station.

Even if, in the enclosed figures, three functional modules 21 are present and vertically arranged, the modularity of the system of course permits making support panels 20 having any number of functional panels 21, which in turn can be arranged in any geometric combination with each other. For example, they can be arranged horizontally, vertically, flanked or according to mixed combination modes, as a function of the size of the longitudinal members 22 of the frame 11, of the under-plate extrusion 14 and/or of the plate 12.

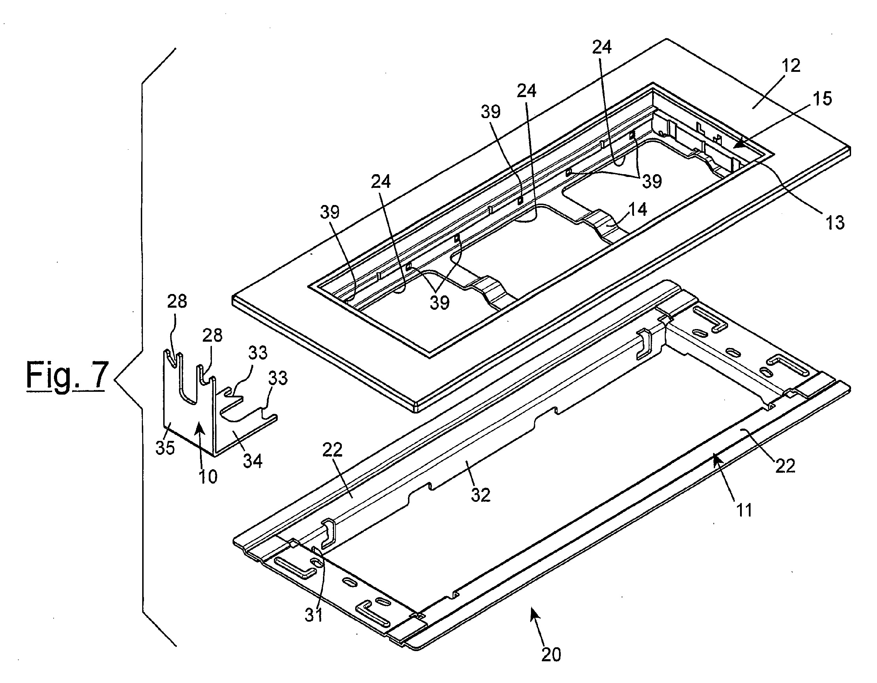

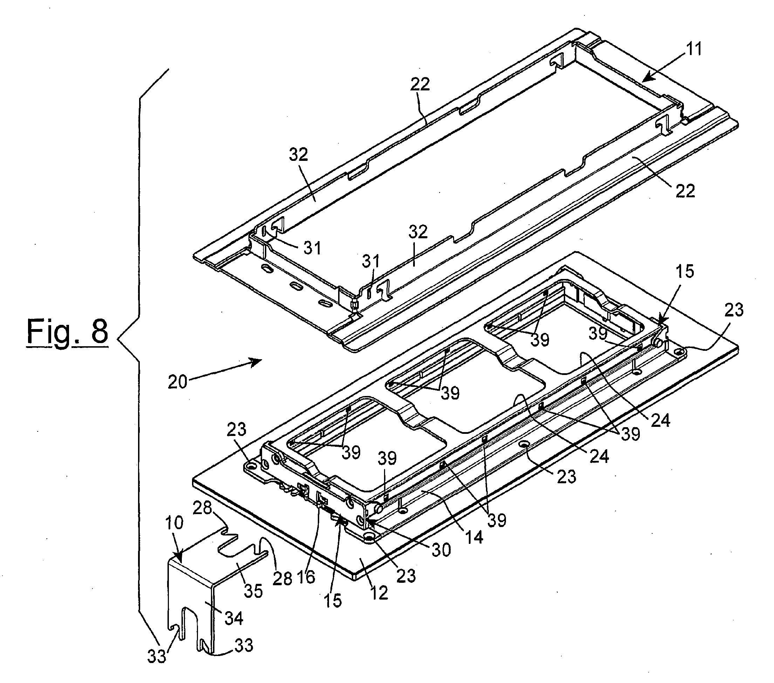

Figures 7 and 8 show the mounting modes of the support panel 20, according to which the shaped frame 11 is first wall-mounted, and then the under-plate extrusion 14 is then set directly on the frame 11, snap-coupled thereto. The extrusion 14 has already been previously connected to the fixing frame 13 and to the plate 12.

In such a manner, the installer can prearrange, in advance and before reaching the site where the support panel 20 will be cabled, the mounting of the extrusion 14 to the fixing frame 13 and to the plate 12, by means of the fixing screws 23. Thus, once onsite, the installer can simply arrange the frame 11 and simply couple the extrusion 14 thereon, such extrusion 14 already complete with fixing frame 13 and plate 12, and finally connect the functional modules 21, which, for their particular manufacture, can be inserted last on the panel 20 by simply coupling them on the front, at the plate 12, inside the seats 24 identified by the extrusion 14.

Such assembly mode is achieved in an extremely simple and functional manner, according to the present invention, by providing for the use of two shaped heads 15, which are fixed to the ends of the extrusion 14 and which are composed of a shaped module 25, directly snapped to the side profile of the extrusion 14, a safety flexure spring 16, placed at the centre of the head 15, within a suitable seat 27, two lateral locking slides 17 and a shaped closure plate 18.

It is thus possible to fix and disassembly, in a quick and easy manner, the under-plate extrusion 14 with respect to the frame 11, without having to provide for the use of visible fixing means and without having to previously dismantle the plate 12 and the fixing frame 13, which therefore, as said, can be advantageously previously mounted on the extrusion 14 and, during the mounting of the frame 11, remain fixed to the aforesaid extrusion 14.

In fact, by means of the simple use of a shaped key 10, it is possible to operate on the elements of each head 15, so to disassemble the extrusion 14 from the frame 11 or lock the aforesaid extrusion 14 on the frame 11; the locking and unlocking operations take place by simply varying the position of the key 10 (as shown in detail in figures 7 and 8).

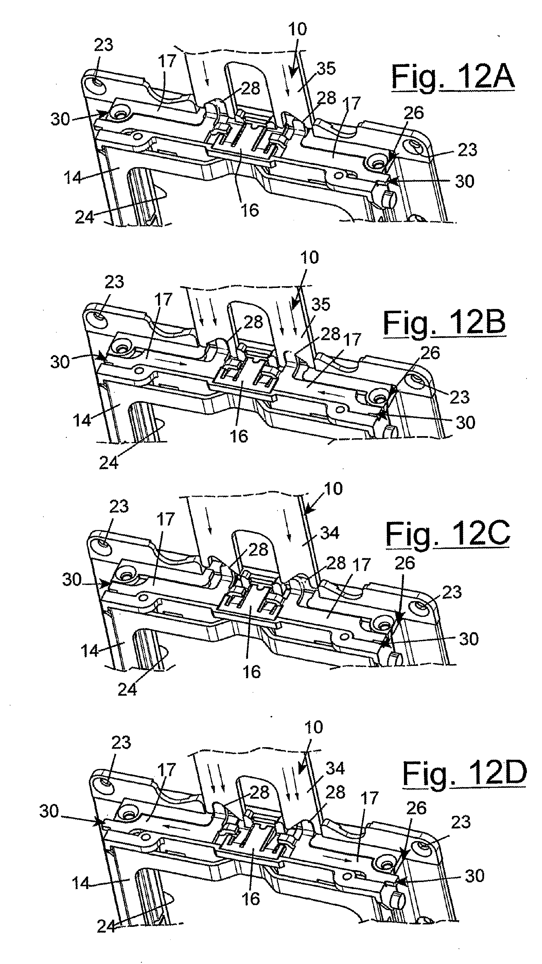

In practice, in the step of opening or unlocking the extrusion 14 from the frame 11 (figures 8, 10 and 12A), first, by bringing closer the key 10, the shaped walls 28 of the portion 35 thereof operate on the appendages 29 of the slides 17, disengaging the safety spring 16; then, by pressing once again with the key 10 (figures 8, 10 and 12B), the appendages 29 of the slides 17 are moved along the sloped plane of the walls 28, causing the inward return of the ends 30, which therefore free the respective inwardly-directed slots 31 made on the walls 32 of the frame 11.

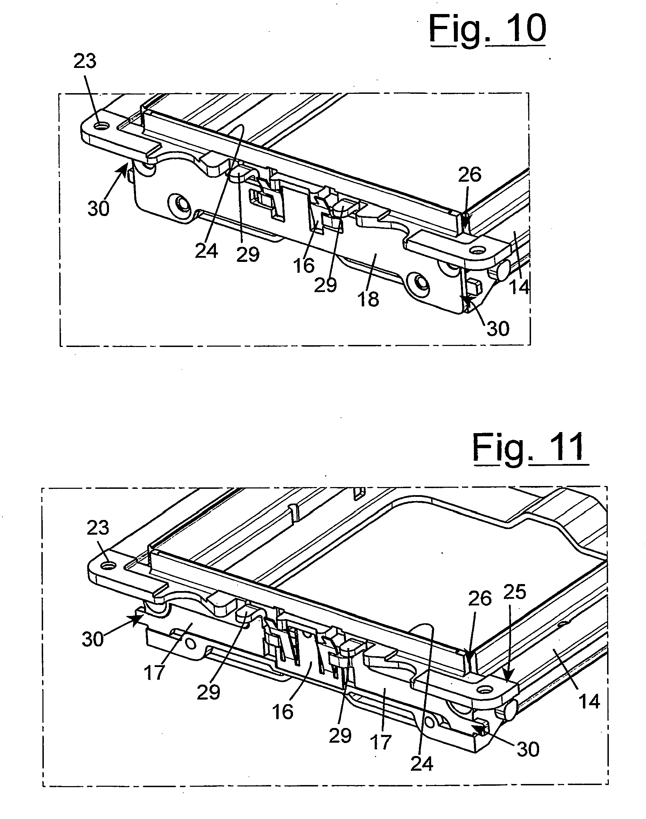

On the other hand, during the step of closing or locking the extrusion 14 on the frame 11 (figures 7, 11 and 12C), by bringing the key 10 closer, overturned with respect to before, the appendages 29 of the locking slides 17 are engaged on the sloped walls 33 of the portion 34 of the key 10, until the closing action is completed, according to which the appendages 29 are outwardly moved, forcing the extraction of the ends 30 of the slides 17, which are coupled in the slots 31 of the sloped walls 32 of the frame 11, and prearranging the safety spring 16 at the locking position. In particular, figure 11 shows in detail the position of the appendages 30 of the slides 17 in closed position, locked in position by the safety spring 16.

In addition, according to exemplifying and preferred but not limiting embodiments, one or more clearance recovery springs 19 are used, inserted in the lateral groove of the extrusion 14.

The assembly and dismantling operations of the support panels 20 of the video entry door stations therefore result quick and easy according to the invention, and can be actuated with the panel 20 directly mounted on the wall or on any fixing surface, since it is sufficient to operate, by means of a suitable key 10, from the bottom of the panel 20 and below the plate 12, by inserting the key 10 between the plate 12 and the frame 11, at one or more heads 15 of the extrusion 14. This permits achieving a concealed fixing of the support panel 20, as well as pre-mounting and pre-cabling of the entire panel 20, it being possible to previously fix the extrusion 14 to the plate 12 and to the fixing frame 13, and connecting the frame 11 directly at the installation site of the panel 20. Still with regard to facilitating and reducing the work times of the system installers, the functional modules 21 have a series of blades 40, adapted to be engaged in respective lateral seats 39 of the under-plate extrusion 14, so to make a fitted mounting of the aforesaid modules 21 within the support panel 20.

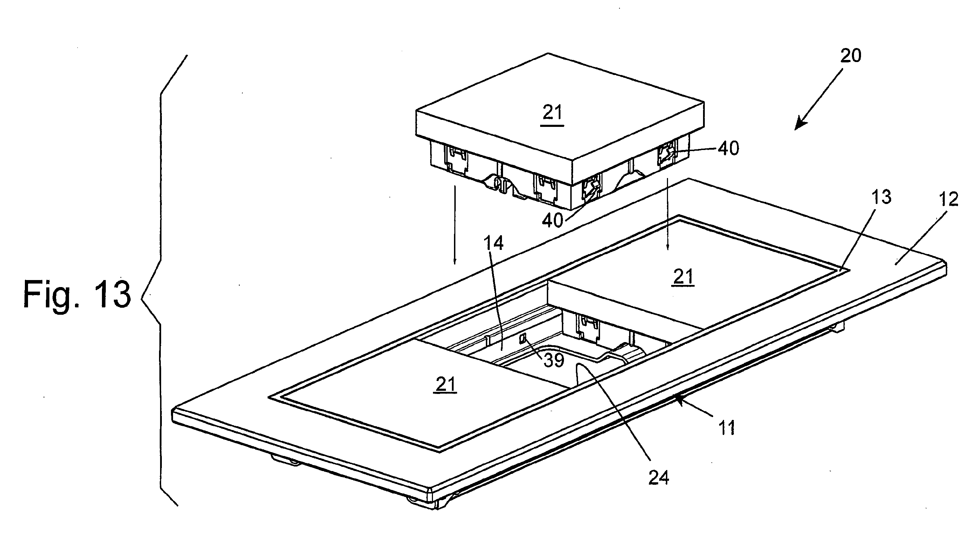

In such a manner, also due to an appropriate sizing of the extrusion 14, fixing frame 13 and plate 12, it is possible for the installer to mount the functional modules 21 from outside the panel 20 directly within the seats 24, with the plate 12 and the extrusion 14 already mounted on the frame 11 (as shown in detail in figure 13).

Thus, the installer can wall-mount the frame 11, fix the extrusion 14, already complete with plate 12 and fixing frame 13, on the frame 11, by means of the concealed fixing system described above, and finally make the electrical connections of each functional module 21, before positioning each module 21 at the respective seat 24, in the front of the panel 20.

The installer can also mount and cable the modules and in the end directly connect the entire system, with a single operation.

The simplicity and quickness of the installation of the support panel 20 is therefore evident, as is the aesthetic advantage determined by the fact that neither holes nor screws or other fixing elements are visible on the front portion of the panel 20 for the mounting of the plate 12 or modules 21; of course, each functional module 21 can also provide for the attachment of suitable identification nameplates of the user, equipped with the respective call button, that can be attached on the front surface of each module 21 by means of adhesive systems or small self-threading screws.

Finally, each functional module 21 can be equipped with a pin hole at the objective of the camera recording the video door entry system and/or other holes, suitably shaped and positioned at the mouth of a microphone and/or loudspeaker (for the conversations with the various users connected to the panel 20).

From the above description, the characteristics of the support panel for video door entry stations with concealed fixing - the object of the present invention - are clear, as are its advantages.

Finally, it is clear that numerous other advantages can be made to the support panel in question, without departing from the novelty principles inherent in the inventive idea, as it is clear that, in the practical actuation of the invention, the materials, shapes and sizes of the illustrated details can be of any type according to requirements, and the same can be substituted with other technically equivalent elements.

## Claims

1. Support panel (20) for video door entry stations with concealed fixing, of the type comprising at least one frame (11), wall-embedded or mounted on at least one base surface, and at least one shaped extruded section bar (14), inside of which a series of functional modules (21) of the video door entry system are housed and on which at least one finishing plate (12) is placed, mounted outside the aforesaid functional modules (21) and supporting the video door entry station, **characterised in that** said extruded section bar (14) is removably fixed to the frame (11), by means of the interposition of at least one head (15), placed transverse to the extruded section bar (14) and below the plate (12), which includes at least one shaped element (25), on which at least one locking slide (17) is mounted having at least one end (30) adapted to be inserted within a respective seat (31) of the frame (11), said slide (17) being maintained in a first extracted position by means of at least one elastic safety element (16) when said safety element (16) is in a first locking position placed within a sliding way of said slide (17), said slide (17) being movable under the action of shaped walls (28) of at least one shaped key (10) between said first extracted position and a second retracted position in which said at least one end (30) is returned inwardly and said respective seat (31) is free when said safety element (16) is brought in a second disengaged position placed outside of said sliding way of said slide (17) under the action of said shaped walls (28) of said at least one shaped key (10).

2. Support panel (20) as in claim 1, **characterised in that** said functional modules (21) are arranged in any geometric combination with each other and/or according to mixed combination modes, as a function of the size of the frame (11), extrusion (14) and/or plate (12).

3. Support panel (20) as in claim 1, **characterised in that** said extruded section bar (14) can be removably coupled to the frame (11), said extrusion (14) being previously mechanically fixed to the plate (12).

4. Support panel (20) as in claim 1, **characterised in that** between said plate (12) and said functional modules (21), at least one finishing and fixing frame (13) is interposed, supporting the support panel (20).

5. Support panel (20) as in claim 1, **characterised in that** said head (15) is fixed to at least one of the ends of the extruded section bar (14) and includes said shaped element (25), directly snapped onto the lateral profile of the extruded section bar (14), said elastic safety element (16), composed of a flexure spring placed at the centre of the head (15) within a suitable seat (27), at least said lateral locking slide (17) and at least one shaped closure plate (18).

6. Support panel (20) as in claim 1, **characterised in that** said shaped key (10) permits releasing or fixing the extruded section bar (14) from/to the frame (11), said releasing and fixing operations being achieved by means of different profiles of said key (10).

7. Support panel (20) as in claim 6, **characterised in that**, in the step of opening or releasing the extruded section bar (14) from the frame (11), first shaped walls (28) are employed of a first portion (35) of the key (10), said first shaped walls (28) being adapted to operate on first appendages (29) of said locking slides (17), so to disengage said elastic safety element (16) and cause the inward return of said ends (30), which therefore free the respective seats (31) made on the inner walls (32) of the frame (11).

8. Support panel (20) as in claim 6, **characterised in that**, in the step of closing or locking the extruded section bar (14) on the frame (11), second shaped walls (33) are employed of a second portion (34) of the key (10), until the closure action is completed, according to which said first appendages (29) of the locking slides (17) are moved towards the outside, forcing the extraction of said ends (30) of the slides (17), which are coupled in the respective seats (31) of the sloped walls (32) of the frame (11), and prearranging said elastic safety element (16) at said locking position.

9. Support panel (20) as in claim 1, **characterised in that** said extruded section bar (14) has at least one lateral channel, where at least one centring spring (19) is inserted for the recovery of the clearances.

10. Support panel (20) as in claim 1, **characterised in that** said functional modules (21), having the video and phonic functions and/or further accessory functions of a video door entry system, have a series of blades (40) on their side, adapted to be engaged in respective lateral seats (39) of the extruded profile (14), so to achieve a fitted mounting of said modules (21), from outside the panel (20) and on the front part thereof, within specific seats (24) of the extruded section bar (14).

## Patentansprüche

1. Trägerplatte (20) für Video-Türsprechstellen mit verborgener Anbringung, umfassend mindestens einen in die Wand eingelassenen oder auf mindestens eine Grundfläche montierten Rahmen (11) und mindestens eine geformte Strangpressprofilschiene (14), in der eine Reihe von Funktionsmodulen (21) der Video-Türsprechanlage untergebracht sind und auf der mindestens eine Abschlussplatte (12) angeordnet ist, die außen um die oben genannten Funktionsmodule (21) montiert ist und die Video-Türsprechstelle trägt, **dadurch gekennzeichnet, dass** die Strangpressprofilschiene (14) durch Einfügen von mindestens einem Kopfstück (15) lösbar am Rahmen (11) befestigt ist, das quer zur Strangpressprofilschiene (14) und unterhalb der Platte (12) angeordnet ist und mindestens ein geformtes Element (25) umfasst, auf das mindestens ein Verriegelungsschieber (17) montiert ist, der mindestens ein Ende (30) aufweist, das geeignet ist, in eine entsprechende Aufnahme (31) des Rahmens (11) eingeführt zu werden, wobei der Schieber (17) mit Hilfe von mindestens einem elastischen Sicherheitselement (16) in einer ersten ausgezogenen Stellung gehalten wird, wenn sich dieses Sicherheitselement (16) in einer ersten Verriegelungsstellung innerhalb eines Schiebewegs dieses Schiebers (17) befindet, wobei der Schieber (17) unter der Einwirkung von geformten Wänden (28) von mindestens einem geformten Schlüssel (10) zwischen der ersten ausgezogenen Stellung und einer zweiten eingezogenen Stellung bewegt werden kann, in der das mindestens eine Ende (30) nach innen zurückgestellt ist, und wobei die entsprechende Aufnahme (31) frei ist, wenn das Sicherheitselement (16) unter der Einwirkung der geformten Wände (28) des mindestens einen geformten Schlüssels (10) in eine zweite ausgerückte Stellung außerhalb des Schiebewegs des Schiebers (17) gebracht ist.

2. Trägerplatte (20) nach Anspruch 1, **dadurch gekennzeichnet, dass** die Funktionsmodule (21) in einer beliebigen geometrischen Kombination miteinander und/oder entsprechend gemischten Kombinationsweisen in Abhängigkeit von der Größe des Rahmens (11), des Strangpressprofils (14) und/oder der Platte (12) angeordnet sind.

3. Trägerplatte (20) nach Anspruch 1, **dadurch gekennzeichnet, dass** die Strangpressprofilschiene (14) lösbar mit dem Rahmen (11) verbunden sein kann, wobei das Strangpressprofil (14) zuvor mechanisch an der Platte (12) befestigt wurde.

4. Trägerplatte (20) nach Anspruch 1, **dadurch gekennzeichnet, dass** zwischen die Platte (12) und die Funktionsmodule (21) mindestens ein Abschluss- und Befestigungsrahmen (13) eingefügt ist, der die Trägerplatte (20) trägt.

5. Trägerplatte (20) nach Anspruch 1, **dadurch gekennzeichnet, dass** das Kopfstück (15) an mindestens einem der Enden der Strangpressprofilschiene (14) befestigt ist und das direkt auf das seitliche Profil der Strangpressprofilschiene (14) aufgeschnappte geformte Element (25), das aus einer in der Mitte des Kopfstücks (15) in einer geeigneten Aufnahme (27) angeordneten Biegefeder bestehende elastische Sicherheitselement (16), mindestens den seitlichen Verriegelungsschieber (17) und mindestens eine geformte Abschlussplatte (18) umfasst.

6. Trägerplatte (20) nach Anspruch 1, **dadurch gekennzeichnet, dass** der geformte Schlüssel (10) das Lösen oder Befestigen der Strangpressprofilschiene (14) vom/am Rahmen (11) gestattet, wobei die Löse- und Befestigungsvorgänge mittels unterschiedlicher Profile des Schlüssels (10) bewerkstelligt werden.

7. Trägerplatte (20) nach Anspruch 6, **dadurch gekennzeichnet, dass** beim Schritt des Ausklinkens oder Lösens der Strangpressprofilschiene (14) vom Rahmen (11) erste geformte Wände (28) eines ersten Abschnitts (35) des Schlüssels (10) verwendet werden, wobei die ersten geformten Wände (28) geeignet sind, auf erste Fortsätze (29) der Verriegelungsschieber (17) einzuwirken, um das elastische Sicherheitselement (16) zu lösen und die Rückkehr nach innen der Enden (30) zu bewirken, die somit die jeweiligen Aufnahmen (31) freigeben, die auf den Innenwänden (32) des Rahmens (11) ausgeführt sind.

8. Trägerplatte (20) nach Anspruch 6, **dadurch gekennzeichnet, dass** beim Schritt des Sperrens oder Verriegelns der Strangpressprofilschiene (14) auf dem Rahmen (11) zweite geformte Wände (33) eines zweiten Abschnitts (34) des Schlüssels (10) eingesetzt werden, bis die Sperrtätigkeit abgeschlossen ist, gemäß der die ersten Fortsätze (29) der Verriegelungsschieber (17) nach außen bewegt werden, wobei sie das Herausziehen der Enden (30) der Schieber (17) erzwingen, die in die jeweiligen Aufnahmen (31) der schrägen Wände (32) des Rahmens (11) eingerückt werden, und das elastische Sicherheitselement (16) in der Verriegelungsstellung voranordnen.

9. Trägerplatte (20) nach Anspruch 1, **dadurch gekennzeichnet, dass** die Strangpressprofilschiene (14) mindestens einen seitlichen Kanal aufweist, in den mindestens eine Zentrierfeder (19) für den Spielausgleich einsetzt ist.

10. Trägerplatte (20) nach Anspruch 1, **dadurch gekennzeichnet, dass** die Funktionsmodule (21) mit den Video-und Audiofunktionen und/oder weiteren Zusatzfunktionen einer Video-Türsprechanlage eine Reihe von Lamellen (40) auf ihrer Seite aufweisen, die dazu geeignet sind, in entsprechende seitliche Aufnahmen (39) des Strangpressprofils (14) eingerastet zu werden, um die genau passende Montage der Module (21) von der Außenseite der Platte (20) und auf deren vorderes Teil in spezielle Aufnahmen (24) der Strangpressprofilschiene (14) zu erhalten.

## Revendications

1. Panneau de support (20) pour postes de portier vidéo avec une fixation masquée, du type comprenant au moins un châssis (11), encastré dans le mur ou monté sur au moins une surface de base, et au moins un profilé extrudé profilé (14), à l'intérieur duquel sont logés une série de modules fonctionnels (21) du système de portier vidéo et sur lequel est placée au moins une plaque de finition (12), montée à l'extérieur des modules fonctionnels précités (21) et supportant le poste de portier vidéo, **caractérisé en ce que** ledit profilé extrudé (14) est fixé de manière amovible au châssis (11), par le biais de l'interposition d'au moins une tête (15), placée transversalement au profilé extrudé (14) et au-dessous de la plaque (12), qui comprend au moins un élément profilé (25), sur lequel est monté au moins un coulisseau de blocage (17) ayant au moins une extrémité (30) adaptée pour être insérée dans un siège respectif (31) du châssis (11), ledit coulisseau (17) étant maintenu dans une première position extraite au moyen d'au moins un élément élastique de verrouillage (16) quand ledit élément de verrouillage (16) est dans une première position de blocage située dans une voie de coulissement dudit coulisseau (17), ledit coulisseau (17) étant déplaçable sous l'action de parois profilées (28) d'au moins une clavette profilée (10) entre ladite première position extraite et une deuxième position rétractée dans laquelle ladite au moins une extrémité (30) est ramenée vers l'intérieur et ledit siège respectif (31) est libre quand ledit élément de verrouillage (16) est amené dans une deuxième position désengagée située à l'extérieur de ladite voie de coulissement dudit coulisseau (17) sous l'action desdites parois profilées (28) de ladite au moins une clavette profilée (10).

2. Panneau de support (20) selon la revendication 1, **caractérisé en ce que** lesdits modules fonctionnels (21) sont agencés entre eux dans n'importe quelle combinaison géométrique et/ou selon des modes de combinaisons mixtes, en fonction des dimensions du châssis (11), de l'extrusion (14) et/ou de la plaque (12).

3. Panneau de support (20) selon la revendication 1, **caractérisé en ce que** ledit profilé extrudé (14) peut être accouplé de manière amovible au châssis (11), ladite extrusion (14) étant préalablement fixée mécaniquement à la plaque (12).

4. Panneau de support (20) selon la revendication 1, **caractérisé en ce que**, entre ladite plaque (12) et lesdits modules fonctionnels (21), est interposé au moins un cadre de finition et de fixation (13) supportant le panneau de support (20).

5. Panneau de support (20) selon la revendication 1, **caractérisé en ce que** ladite tête (15) est fixée à au moins une des extrémités du profilé extrudé (14) et comprend ledit élément profilé (25), directement encliqueté sur le profil latéral du profilé extrudé (14), ledit élément élastique de verrouillage (16), constitué par un ressort de flexion placé au centre de la tête (15) dans un siège correspondant (27), au moins ledit coulisseau de blocage latéral (17) et au moins une plaque de fermeture profilée (18).

6. Panneau de support (20) selon la revendication 1, **caractérisé en ce que** ladite clavette profilée (10) permet la libération ou la fixation du profilé extrudé (14) du/au châssis (11), lesdites opérations de libération et fixation étant réalisées au moyen de profils différents de ladite clavette (10).

7. Panneau de support (20) selon la revendication 6, **caractérisé en ce que**, dans l'étape d'ouverture ou libération du profil extrudé (14) par rapport au châssis (11), des premières parois profilées (28) d'une première portion (35) de la clavette (10) sont utilisées, lesdites premières parois profilées (28) étant adaptées pour agir sur des premiers appendices (29) desdits coulisseaux de blocage (17), de manière à désengager ledit élément élastique de verrouillage (16) et entraîner le retour vers l'intérieur desdits extrémités (30), lesquelles libèrent ainsi les sièges respectifs (31) réalisés sur les parois intérieures (32) du châssis (11).

8. Panneau de support (20) selon la revendication 6, **caractérisé en ce que**, dans l'étape de fermeture ou blocage du profilé extrudé (14) sur le châssis (11), des deuxièmes parois profilées (33) d'une deuxième portion (34) de la clavette (10) sont utilisées, jusqu'à ce que l'action de fermeture soit terminée, moyennant quoi lesdits premiers appendices (29) des coulisseaux de blocage (17) sont déplacés vers l'extérieur, en entraînant l'extraction desdites extrémités (30) des coulisseaux (17), lesquelles sont accouplées dans les sièges respectifs (31) des parois inclinées (32) du châssis (11), et en prédisposant ledit élément élastique de verrouillage (16) dans ladite position de blocage.

9. Panneau de support (20) selon la revendication 1, **caractérisé en ce que** ledit profilé extrudé (14) a au moins un canal latéral dans lequel est inséré au moins un ressort de centrage (19) pour la récupération des jeux.

10. Panneau de support (20) selon la revendication 1, **caractérisé en ce que** lesdits modules fonctionnels (21), ayant les fonctions vidéo ou audio et/ou d'autres fonctions auxiliaires d'un système de portier vidéo, comporte une série de lames (40) sur leur côté, adaptées pour s'engager dans des sièges latéraux respectifs (39) du profilé extrudé (14), de manière à réaliser un montage serré desdits modules (21), à partir de l'extérieur du panneau (20) et sur la partie frontale de celui-ci, dans des sièges spécifiques (24) du profilé extrudé (14).
